Europäisches Patentamt

European Patent Office

Office européen des brevets

(19)

(11) Publication number: **0 199 890 B1**

# EUROPEAN PATENT SPECIFICATION

(45) Date of publication of patent specification: **27.03.91**

(51) Int. Cl.⁵: **G05B 19/04**, H03K 19/173, H03K 19/177

(21) Application number: **86100556.9**

(22) Date of filing: **17.01.86**

(54) A self-sequencing logic circuit.

(30) Priority: **30.04.85 US 728719**

(43) Date of publication of application:
**10.12.86 Bulletin 86/45**

(45) Publication of the grant of the patent:
**27.03.91 Bulletin 91/13**

(84) Designated Contracting States:
**DE FR GB IT**

(56) References cited:
**GB-A- 2 034 090**
**US-A- 4 075 707**
**US-A- 4 237 542**

**1974 IEEE INTERCON TECHNICAL PROGRAM PAPERS, 26th - 29th March 1974, New York, US, session 1, Electronic calculators: market, design, applications; M.H. GRAFF: "Prom based fast logic systems"**

(73) Proprietor: **International Business Machines Corporation**
**Old Orchard Road**
**Armonk, N.Y. 10504(US)**

(72) Inventor: **Pearson, Kenneth Arnold**
**209 Hinsdale Street**
**Kingston New York 12401(US)**
Inventor: **Zucker, Larry Reed**
**3 Hemlock Court**
**Saugerties New York 12477(US)**

(74) Representative: **Harris, Ian Richard**
**IBM United Kingdom Limited Intellectual Property Department Hursley Park**
**Winchester, Hants. SO21 2JN(GB)**

## Description

The present invention relates to self-sequencing logic circuits implemented in random access storage.

A self-sequencing logic circuit, if able to respond adequately to inputs is capable of performing controller functions within a greater combination of which it is a part. If implemented in random access storage it has, other things being equal, the potential for flexibility and change. If implemented as fixed logic circuits, it can be expected to be faster than a random access storage counterpart, if lacking in flexibility. There is much art in this area and the following are systems representative thereof, with accompanying comment in relation to the present invention as set forth in the claims.

US-A-4,357,678 discloses an arrangement in which a random access memory is used for performing logic functions. However, the arrangement requires that the entire array be searched sequentially on each functional cycle, and this slows the operation considerably. Further, US-A-4,357,678 teaches a system which multiplexes inputs and outputs and does not provide for logic controlled feedback from output to input.

US-A-4,348,737 includes a random access memory array for performing logic functions which requires an entire array to be searched sequentially once every functional cycle as does US-A-4,357,678.

The logic array according to the present invention does not require a search of the entire array for each cycle as does the arrangement of either referenced patent and thus the array of the present invention provides a much faster operation than does either of the other arrangements.

IBM Technical Disclosure Bulletin, Volume 17, Number 10 March 1975, page 2867, describes array logic implemented within a random access memory with a feedback system where the outputs directly generate the next address to be accessed in the RAM. The article describes an array logic RAM which is very restricted in its operation and does not provide the flexibility which is provided by the logic array of the present invention.

US-A-4 075 707 discloses an extension to the kind of arrangement just described, increasing flexibility by providing three uses of - three definitions of the meaning of - the bit pattern currently output from the storage array. However there is still only the single storage array which still provides one output bit pattern per presented address.

US-A-4,336,601 describes a rewritable program logic array which is dynamically alterable during processing by loading a word pattern of bit personalities to realise specific logic functions into memory cells of current mode logic by splitting a conventional RAM of current mode logic into two parts, a search part and a read part. The logic in memory for the AND functions on the array can be conducted by using one of the multi-emitters of a transistor in each current mode logic memory cell and an emitter of a referenced transistor in each of the sense drive circuits in the read mode of the rewritable program logic array.

The structure according to US-A-4,336,601 requires a specific technology, namely CML, to implement the logic in memory functions whereas no specific technology is required to realise the present invention.

US-A-4,237,542 describes a programmable logic array of the well-know type which does not employ a random access memory for its implementation as does the array in accordance with the present invention.

US-A-3,818,452 describes a fusable link programmable logic array for use in designing digital systems. The patent does not teach the use of random access memory to perform logic functions as does the arrangement of the present invention.

US-A-3,829,846 describes a multi-function logic module employing read only associative memory arrays. The logic system of the patent does not show the use of random access memories as does the arrangement of the present invention.

CLARE, "Designing Logic Systems Using State Machines", 1973; McGraw-Hill Book Company, at pages 76-90, describes a programmable logic structure implemented in a random access memory. However, the various structures shown by CLARE are limited in application in that feedback between output and input must be hard wired for specific functions as compared to the feedback system of the present invention which is implemented by a feedback array. Further, the CLARE structure does not permit subroutines to be implemented as does the present invention. Additionally, Clare avoids the use of "don't care" conditions on inputs and "don't change" conditions on outputs by limiting operation to one (1) input line per state. That is, Clare sorts multiple simultaneous inputs with a hardware data selector and has no way of assuring that those input lines already tested, are still in the same state. Clare ignores inputs by selecting a tied input and treats outputs as full-width outputs without the ability to selectively change the same.

Although the prior art shows similar functions and use of random access memory to implement program logic arrays, none of the prior neither individually nor in any combination thereof teaches the present invention as claimed herein.

In particular, a fixed logic implementation can happily wait on the arrival of the next clock till whenever, whereas, a random access storage implementation, as in CLARE, for example, dies without a next address or is forced by timing constraints to a default address. Therefore, to obtain flexibility and the capacity to wait, the present invention provides a self-sequencing logic circuit comprising an input storage array having addressable locations for storing input control words; input logic receiving control words from the input storage array and also input signals and producing signals indicating the relationship between conditions represented by the input signals and conditions represented by the control words; output logic providing binary output signals; an output storage array having addressable locations for storing output control words for controlling the state of the output logic; a next address storage array identifying a next address from one of plurality of fields within the next address array; address generating logic receiving address signals from the next address storage array and applying such address signals to address circuits of the input, output and next address storage arrays; and control logic connecting the input logic to the output logic and responsive to signals produced by the input logic to enable the output logic to respond to selected output control words.

Put another way, there is disclosed hereinafter a programmable, sequential logic array for performing logical operations within a memory array, comprising: an input storage array having addressable locations for storing input control words; input means for receiving a plurality of input signals and control words from said input storage array and producing signals indicating the relationship between conditions of said input signals and conditions represented by said control words; output means for providing binary output signals; an output storage array having addressable locations for storing output control words for controlling a state of said output means; a next address storage array for identifying a next address from one of plurality of fields within said next address array; address generation means for receiving address signals from said said next address storage array and for applying said address signals to address circuits of said input storage array, said output storage array, and said next address storage array; and control means connecting said input means to said output means and responsive to signals produced by said input means to enable said output means to respond to selected output control words.

The present invention will be described further by way of example with reference to an embodiment thereof as illustrated, together with an example of one item of prior art, in the accompanying drawings in which:-

Figure 1 is a block diagram of a prior art programmable logic array implemented by a combination of random access memory and read only storage;

Figure 2 is a block diagram of one form of programmable logic system according to the present invention;

Figure 3 is a logic diagram, partly in the form of a table, of one form of interface gating means used in the system of Figure 2; and

Figure 4, in sections 1,2 and 3, is a circuit board lay-out diagram of the logic system of Figure 2.

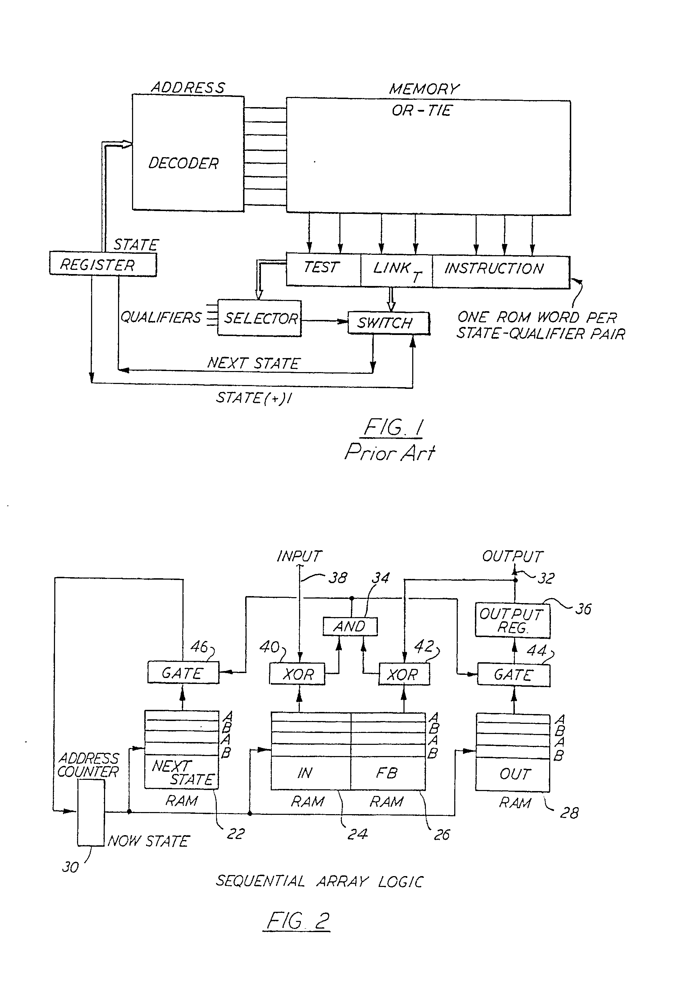

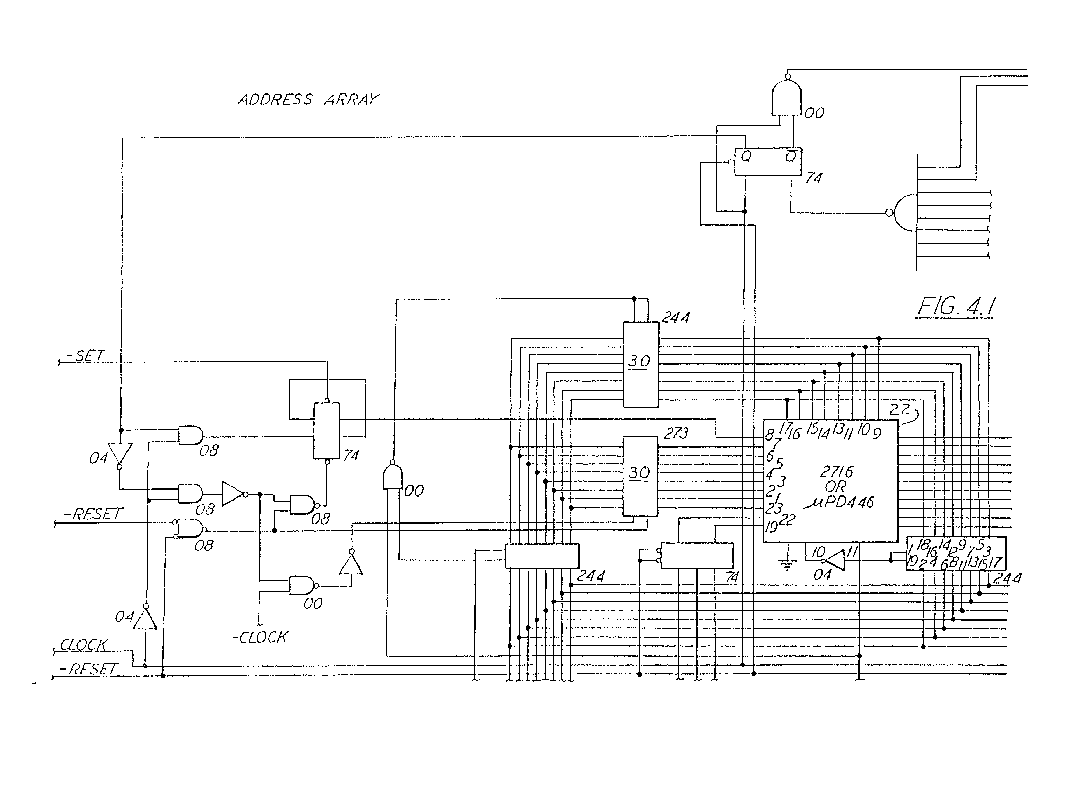

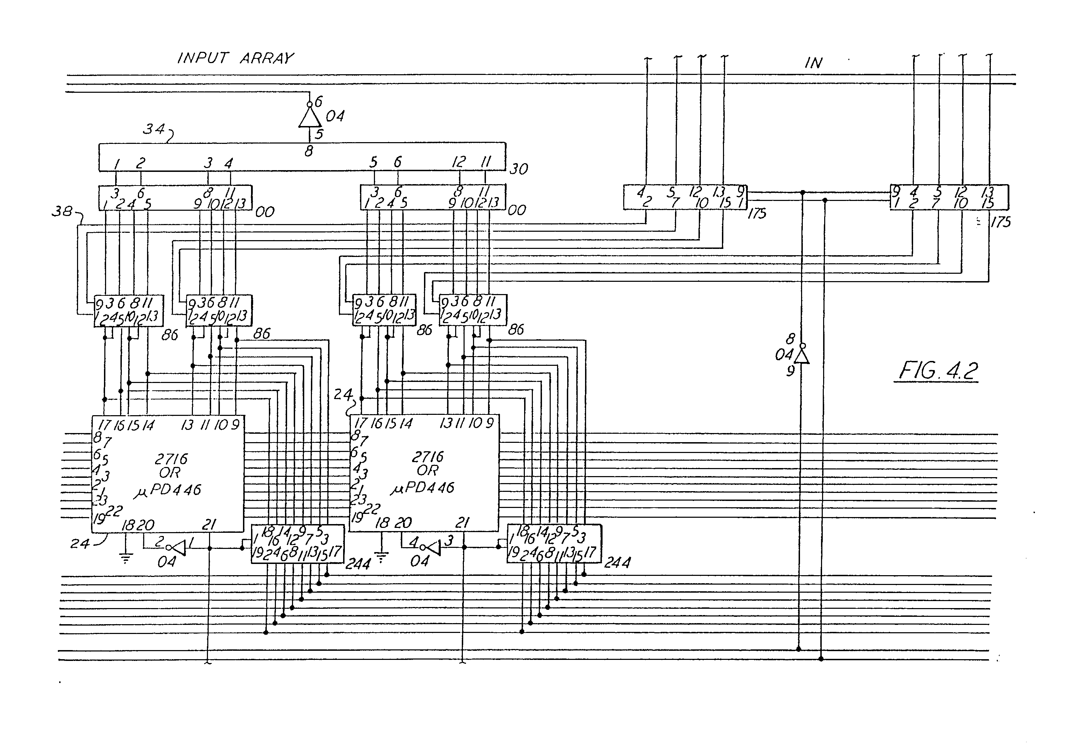

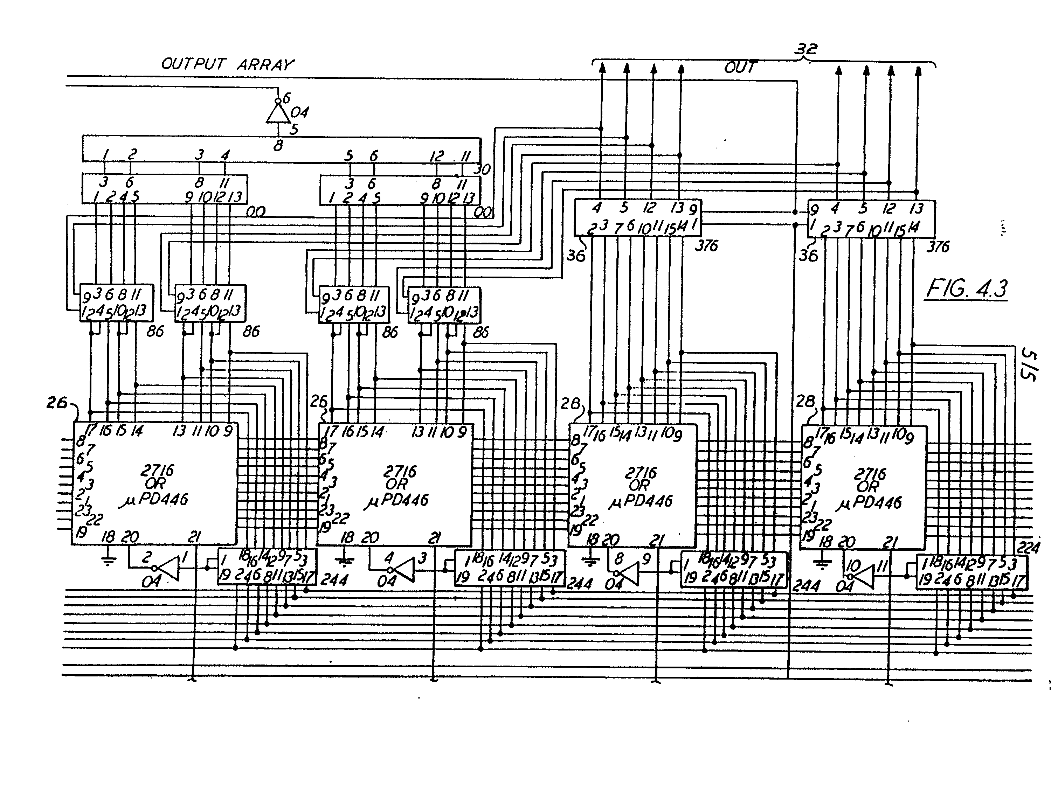

The selected example of a prior art logic array, shown in Figure 1, is that of Figure 5.15, page 81, of the referenced CLARE article and includes an address generator section and an output section. Part of the address generator section is located in the random access storage of the output section and includes a TEST field and a LINK field. The system is arranged to move to a state defined by LINK field T if the TEST field matches the qualifiers entered into a selector or, unavoidably, as an automatic default, to that state which is logically NEXT to the current state. CLARE also references (Figure 5.13) an alternative in which there are two LINK fields and no NEXT operation, but the parallel default limitation obtains. These prior art systems include a read only storage for decoding the addresses so generated. In either arrangement, CLARE indicated a preference for bit-sequential testing, so that, if an early bit has not settled, even though it is on the point of so doing, the arrangement will per force branch away from the path that the tested bit would have indicated.

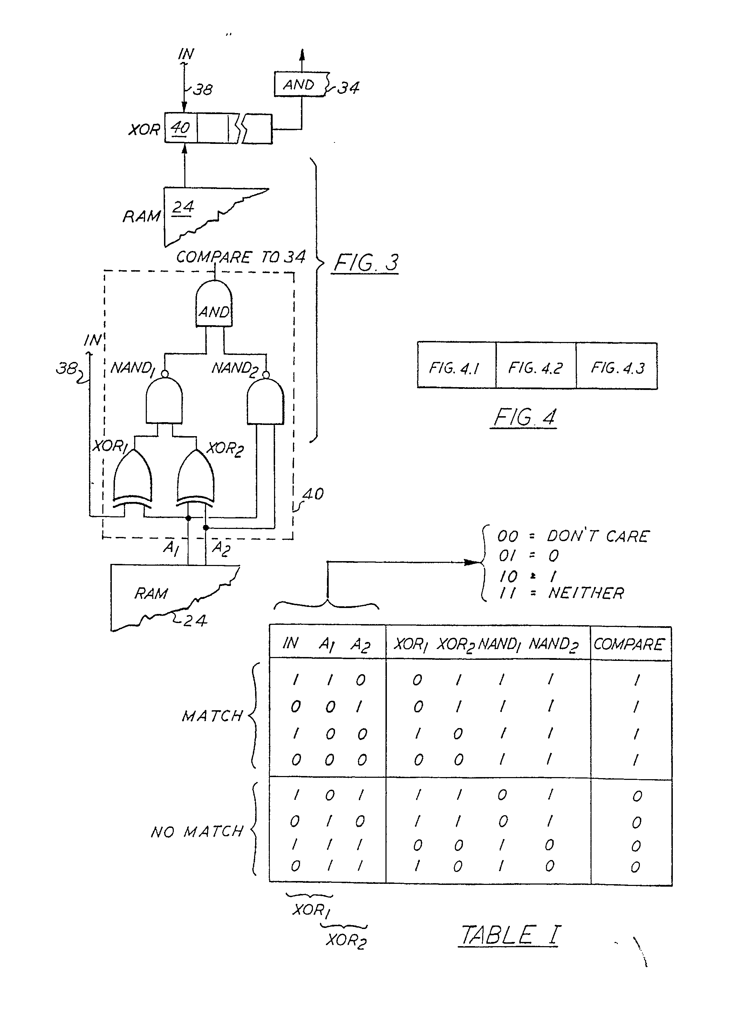

Turning to the present invention, illustrated in varying degrees of detail in Figures 2, 3 and 4, a array of four logical (though seven physical, see Figure 4) random access storage arrays 22, 24,26,28 are arranged, in combination with supporting logic, to perform the functions of a programmable logic array.

The four RAM arrays 22, 24, 26 and 28 are all addressed in parallel by an output from address counter 20. The contents of the four arrays 22, 24, 26 and 28 are read out corresponding to the address contained in address counter 30.

A functional cycle from input to output is comprised of two parts (an A-part and a B-part). In the A-part, the array contents pointed to by the address counter 30 are read, though not all necessarily used, and then, conditionally, in the B-part, the contents pointed to by the next consecutive address are similarly read, the address counter being updated by part thereof or returned to its A-part value.

The values for updating the address counter come from the next state array 22, which is divided into portions A and B, where the A portion of the array stores a next address corresponding to a compare on the A-part of a cycle and the B portion of the array stores a next address corresponding to a compare on the B-part of a cycle.

During the A- part of a cycle, the contents of input array 24, at location A thereof, are compared with input lines 38 bit by bit by exclusive OR (XOR) 40. Similarly, the contents of the corresponding A location of the feedback array 26 are compared, by XOR 42 with the current output on lines 32. If a true compare exists in both cases, XORs 40 and 42 both produce a true signal to AND gate 34. AND gate 34 produces a true signal to control gates 44 and 46 in respective data paths to the output 32 and the address counter 30. The contents of location A in output array 28 are gated to output register 36 by gates 44, and the contents of location A in the next state array 22 are gated by gates 46 to address counter 30. This results in the four arrays, 22, 24 26 and 28 being addressed at the A portion of a new current cycle.

If the compare fails on either the input from lines 38 or feedback from lines 32, the address counter 30 is incremented by one and the B-part of the cycle is entered so that the counterpart B locations of the arrays 22, 24, 26 and 28 are selected. A compare on both input and feedback results in the B data being transferred to the output 32 and address counter 30. If the compare fails on either count in the B cycle, address counter is decremented by one and another A-B cycle is started at the same address location. This means that the current state remains unchanged until a full compare is obtained on some subsequent A-B cycle, and this depends on changes to the input on lines 38.

The compare is shown in detail in Figure 3 and accompanying Table 1. Two bits, A1 and A2, are used in the input array 24 and feedback array 26 to represent one four-state functional bit as shown in Table 1.

Table 1 describes the coding mechanism of the present arrangement which permits the selective ignoring of a predetermined status condition represented by code 00 (don't care) for bits A1 and A2. The other three states represent;-

    code 01    0,
    code 10    1, and
    code 11    no match, since for these
paired state values, a compare is prohibited no matter what the input values are.

Two bits are also used in output array 28 to change one functional output bit according to the following Table 2:

Table 2

| | | |
|---|---|---|
| 00 | = | no change |
| 01 | = | clear |
| 10 | = | set |
| 11 | = | toggle |

The result of the arrangement is that outputs can be made to change in response to inputs, in the same way as is done in a fixed circuit program logic array, and in a worst case time interval of twice the cycle time of the random access memory or erasable programmable read only memory used, which are nominally in the 70-300 nano-second range. The response time can be reduced to one array cycle if the number of arrays is doubled, allowing the A and B data to be in separate arrays.

The detailed logic of the preferred embodiment of the present invention as described with reference to Figure 2 is shown in Figures 4.1, 4.2 and 4.3 Figures 4.1, 4.2 and 4.3 contain specific component and interconnection information and provide sufficient detail to enable a person skilled in the art to reproduce a logic system in accordance with the present invention.

## Claims

1. A self-sequencing logic circuit comprising an input storage array (24) having addressable locations for storing input control words; input logic (40) receiving control words from the input storage array and also input signals (on 38) and producing signals indicating the relationship between conditions represented by the input signals and conditions represented by the control words; output logic (36) providing binary output signals; an output storage array (28) having addressable locations for storing output control words for controlling the state of the output logic; a next address storage array (22) identifying a next address from one of plurality of fields within the next address array; address generating logic (46,30) receiving address signals from the next address storage array and applying such address signals to address circuits of the input, output and next address storage arrays; and control logic (44) connecting the input logic to the output logic and responsive to signals produced by the input logic to enable the output logic to respond to selected output control words.

2. A circuit as claimed in claim 1, further including an output state storage array (26) having addressable locations for storing output state definitions and output state logic (42), connected to the output (32) and to the output state storage array to test for the output to correspond to the addressed output state definition currently addressed in the output state storage array, together with AND logic (34), responsive to both the input logic and the output state logic, to enable the address generation logic when the input and output states meet the specified criteria.

3. A circuit as claimed in claim 2, wherein the fields of the next address storage array identified by an address define sets of potential new addresses and a new address is generated by selecting one of a predetermined set of potential new addresses, the address generating logic including an address counter (30) and selective gating (46) connecting the output of the next address storage array to the address counter when enabled, the gating being enabled by the AND logic (34) if and only if there is a particular correspondence between the input, feedback and generated signals, or else, to dwell, without gating any output via control logic (44) until such a particular correspondence is detected.

4. A circuit as claimed in either claim 2 or claim 3, wherein the selective gating is arranged to increment/decrement the address counter, if there is no detected correspondence, and to reset the address counter to the accessed value in the address storing random access storage, if correspondence is detected, the data of a set in any storage being located at logically adjacent addresses.

5. A circuit as claimed in claim 4, wherein the output data in the output storage array (28) is similarly arranged and located by set.

6. A circuit as claimed in any of claims 2 to 5, wherein the input storage array and the output state storage array are, or are effectively, comprised of four state cells, thus providing "don't care", "1", "0" and "no match" outputs.

**Revendications**

1. Circuit logique auto-séquencé comprenant un agencement de mémoire d'entrée (24) ayant des emplacements adressables pour stocker des mots de commande d'entrée ; une logique d'entrée (40) recevant des mots de commande de l'agencement de mémoire d'entrée et également des signaux d'entrée (sur 38) et produisant des signaux indicatifs de la relation entre les conditions représentées par les signaux d'entrée et les conditions représentées par les mots de commande ; une logique de sortie (36) fournissant des signaux de sortie binaires ; un agencement de mémoire de sortie (28) ayant des emplacements adressables pour stocker des mots de commande de sortie afin de commander l'état de la logique de sortie ; un agencement de mémoire d'adresse suivante (22) identifiant une adresse suivante à partir de l'un d'une pluralité de champs dans l'agencement de mémoire d'adresse suivante ; une logique de génération d'adresse (46,30) recevant des signaux d'adresse à partir de l'agencement de mémoire d'adresse suivante et appliquant ces signaux d'adresse à des circuits d'adresse des agencements de mémoire d'entrée, de sortie et d'adresse suivante ; et une logique de commande (44) reliant la logique d'entrée à la logique de sortie et répondant aux signaux produits par la logique d'entrée de manière à permettre à la logique de sortie de répondre aux mots de commande de sortie choisis.

2. Circuit suivant la revendication 1, comprenant en outre un agencement de mémoire d'état de sortie (26) ayant des emplacements adressables pour stocker des définitions d'état de sortie et une logique d'état de sortie (42), connectée à la sortie (32) et à l'agencement de mémoire d'état de sortie pour vérifier que la sortie correspond à la définition d'état de sortie adressée présentement adressée dans l'agencement de mémoire d'état de sortie, en combinaison avec une logique ET (34), répondant à la fois à la logique d'entrée et à la logique d'état de sortie, de manière à activer la logique de génération d'adresse lorsque les états d'entrée et de sortie correspondent aux critères spécifiés.

3. Circuit suivant la revendication 2, dans lequel les champs de l'agencement de mémoire d'adresse suivante identifiés par une adresse définissent des ensembles de nouvelles adresses potentielles et une nouvelle adresse est générée par sélection d'une adresse dans un ensemble prédéterminé de nouvelles adresses potentielles, la logique de génération d'adresse comprenant un compteur d'adresse (30) et une porte sélective (46) reliant la sortie de l'agencement de mémoire d'adresse suivante au compteur d'adresse lorsqu'elle est activée, la porte étant activée par la logique ET (34) si et seulement s'il y a une correspondance particulière entre les signaux d'entrée, de réaction et générés, ou sinon, demeurant en l'état, sans transférer de sortie par l'intermédiaire de la logique de commande (44) jusqu'à ce qu'une telle correspondance particulière soit détectée.

4. Circuit suivant la revendication 2 ou la revendication 3, dans lequel la porte sélective est prévue pour incrémenter/décrémenter le compteur d'adresse, s'il n'y a pas de correspondance détectée, et pour ramener le compteur d'adresse à la valeur accédée dans la mémoire vive de stockage d'adresse, si une correspondance est détectée, les données d'un ensemble dans une mémoire quelconque étant situées à des adresses logiquement adjacentes.

5. Circuit suivant la revendication 4, dans lequel les données de sortie dans l'agencement de mémoire de sortie (28) sont disposées de façon similaire et placées par ensemble.

6. Circuit suivant l'une quelconque des revendications 2 à 5, dans lequel l'agencement de mémoire d'entrée et l'agencement de mémoire d'état de sortie sont, ou sont effectivement, constitués de cellules à quatre états, fournissant ainsi des sorties "indifférent", "1", "O" et "non concordance".

## Ansprüche

1. Selbstordnende Logikschaltung mit einer Eingabe-Speicheranordnung (24), die adressierbare Stellen zum Speichern von Eingabe-Steuerworten besitzt, einer Eingabe-Logik (40), die von der Eingabe-Speicheranordnung Steuerworte und auch Eingabesignale (auf 38) empfängt und Signale erzeugt, welche die Beziehung zwischen durch die Eingabesignale dargestellten Zuständen und durch die Steuerworte dargestellten Zuständen anzeigen, einer Ausgabe-Logik (36), die binäre Ausgabesignale liefert, einer Ausgabe-Speicheranordnung (28), die adressierbare Stellen zum Speichern von Ausgabe-Steuerworten zum Steuern des Zustandes der Ausgabe-Logik besitzt, einer nächster Adreß-Speicheranordnung (22), die eine nächste Adresse von einem einer Mehrzahl von Feldern innerhalb der nächsten Adreßanordnung identifiziert, einer Adreßerzeugungs-Logik (46, 30), die von der nächsten Adreß-Speicheranordnung Adreßsignale empfängt und solche Adreßsignale den Adreßschaltungen der Eingabe-, Ausgabe- und der nächsten Adreß-Speicheranordnungen zuführt und einer Steuerlogik (44), welche die Eingabe-Logik mit der Ausgabe-Logik verbindet und auf Signale anspricht , die durch die Eingabe-Logik erzeugt werden, um die Ausgabe-Logik zu aktivieren, auf ausgewählte Ausgabe-Steuerworte zu antworten.

2. Schaltung nach Anspruch 1, die ferner aufweist: eine Ausgabezustands-Speicheranordnung (26) mit adressierbaren Stellen zum Speichern von Ausgabezustand-Definitionen und eine Ausgabezustand-Logik (42), die mit der Ausgabe (32) und mit der Ausgabezustands-Speicheranordnung verbunden ist, um das Entsprechen der Ausgabe der adressierten Ausgabezustand-Definition zu prüfen, die in der Ausgabezustands-Speicheranordnung augenblicklich adressiert wird, zusammen mit einer AND-Logik (34), die sowohl auf die Eingabe-Logik als auch die Ausgabezustand-Logik anspricht, um die Adreßerzeugungs-Logik zu aktivieren, wenn die Eingabe- und Ausgabezustände die spezifizierten Kriterien erfüllen.

3. Schaltung nach Anspruch 2, bei welcher die Felder der nächsten Adreß-Speicheranordnung, die durch eine Adresse identifiziert wird, Sätze potentiell neuer Adressen definieren und eine neue Adresse durch das Auswählen einer eines vorbestimmten Satzes potentiell neuer Adressen erzeugt wird, die Adreßerzeugungs-Logik einen Adreßzähler (30) und eine selektive Torsteuerung (46) aufweist, welche die Ausgabe der nächsten Adreß-Speicheranordnung mit dem Adreßzähler verbindet, wenn sie aktiviert wird, wobei die Torsteuerung durch die AND-Logik (34) dann und nur dann aktiviert wird, wenn es eine besondere Entsprechung zwischen den Eingabe-, Rückkopplungs-und erzeugten Signalen gibt oder andernfalls um zu verweilen, ohne über eine Steuerlogik (44) irgendeine Ausgabe einer Torsteuerung zu unterwerfen, bis eine solche besondere Entprechung erfaßt wird.

4. Schaltung entweder nach Anspruch 2 oder Anspruch 3, bei welcher die selektive Torsteuerung eingerichtet ist, um den Adreßzähler zu inkrementieren - dekrementieren, wenn es keine erfaßte Ensprechung gibt und um den Adreßzähler auf den Zugriffswert in dem adreßspeichernden Speicher mit wahlfreiem Zugriff zurückzusetzen, wenn eine Entsprechung erfaßt wird, wobei sich die Daten eines Satzes in irgendeinem Speicher an logisch benachbarten Adressen befinden.

5.  Schaltung nach Anspruch 4, bei welcher die Ausgabedaten in der Ausgabe-Speicheranordnung (28) ähnlich geordnet und durch einen Satz lokalisiert werden.

6.  Schaltung nach irgend einem der Ansprüche 2 bis 5, bei welcher die Eingabe-Speicheranordnung und die Ausgabe-Speicheranordnung aus oder auf eine effektive Art aus vier Zustandszellen bestehen, wodurch "nicht zu beachtende"-, "1"-, "0"- und "keine Obereinstimmung"-Ausgaben geliefert werden.

ADDRESS

MEMORY

OR - TIE

DECODER

STATE

REGISTER

TEST | LINK_T | INSTRUCTION

ONE ROM WORD PER
STATE-QUALIFIER PAIR

QUALIFIERS ── SELECTOR ──→ SWITCH

NEXT STATE

STATE (+)I

*FIG. 1*
*Prior Art*

INPUT          OUTPUT

38   34        32

AND            OUTPUT   36
               REG.

46    40       42    44

GATE   XOR     XOR    GATE

A        A        A
B        B        B
A        A        A
B        B        B

ADDRESS
COUNTER

NEXT
STATE     IN    FB      OUT

RAM       RAM   RAM     RAM   28

NOW STATE    22      24    26

30

SEQUENTIAL ARRAY LOGIC

*FIG. 2*

FIG. 3

FIG. 4

| FIG. 4.1 | FIG. 4.2 | FIG. 4.3 |
|----------|----------|----------|

$\begin{cases} 00 = DON'T\ CARE \\ 01 = 0 \\ 10 = 1 \\ 11 = NEITHER \end{cases}$

| IN | $A_1$ | $A_2$ | $XOR_1$ | $XOR_2$ | $NAND_1$ | $NAND_2$ | COMPARE |
|----|-------|-------|---------|---------|----------|----------|---------|
| 1 | 1 | 0 | 0 | 1 | 1 | 1 | 1 |
| 0 | 0 | 1 | 0 | 1 | 1 | 1 | 1 |
| 1 | 0 | 0 | 1 | 0 | 1 | 1 | 1 |
| 0 | 0 | 0 | 0 | 0 | 1 | 1 | 1 |
| 1 | 0 | 1 | 1 | 1 | 0 | 1 | 0 |
| 0 | 1 | 0 | 1 | 1 | 0 | 1 | 0 |
| 1 | 1 | 1 | 0 | 0 | 1 | 0 | 0 |
| 0 | 1 | 1 | 1 | 0 | 1 | 0 | 0 |

MATCH (rows 1–4)

NO MATCH (rows 5–8)

TABLE I

ADDRESS ARRAY

FIG. 4.1

EP 0 199 890 B1

INPUT ARRAY

IN

FIG. 4.2

EP 0 199 890 B1

FIG. 4.3